# EUROPÄISCHE PATENTSCHRIFT

(11) **EP 0 520 355 B1**
(45) Veröffentlichungstag und Bekanntmachung des Hinweises auf die Patenterteilung: **06.12.1995**
(21) Anmeldenummer: 92110493.1
(22) Anmeldetag: 22.06.1992
(51) Int. Cl.: H01L 29/74

(54) **Mittels Steuerelektrode abschaltbares Leistungshalbleiter-Bauelement sowie Verfahren zu dessen Herstellung**
Gate turn-off semi-conductor power component and method of making the same
Composant semi-conducteur de puissance à commande d'extinction et procédé de sa fabrication

(30) Priorität: 28.06.1991 DE 4121375
(43) Veröffentlichungstag der Anmeldung: 30.12.1992
(73) Patentinhaber: ASEA BROWN BOVERI AG, 5400 Baden (CH)
(72) Erfinder: Johansson, Kenneth, CH-5415 Nussbaumen (CH); Lilja, Klas, CH-5442 Fislisbach (CH); Stockmeier, Thomas, Dr., CH-5303 Würenlingen (CH)

(56) Entgegenhaltungen:
- EP-A- 0 424 710
- EP-A- 0 454 201
- EP-A- 0 487 869
- DE-A- 3 447 220
- DE-A- 4 011 509

## Beschreibung

### TECHNISCHES GEBIET

Die vorliegende Erfindung bezieht sich auf das Gebiet der Leistungselektronik. Sie betrifft ein abschaltbares Leistungshalbleiter-Bauelement, umfassend
(a) ein flächiges Halbleitersubstrat mit zwei gegenüberliegenden Hauptoberflächen, von denen die erste als Anode und die zweite als Kathode ausgebildet ist;
(b) in dem Halbleitersubstrat zwischen der Anode und der Kathode eine lateral durchgehende, n⁻-dotierte n-Basisschicht, eine p⁺-dotierte Anodenschicht, welche von der Anodenseite her in die n-Basisschicht eingelassen und auf der ersten Hauptoberfläche mit einem Anodenkontakt versehen ist, und eine p⁺-dotierte p-Basisschicht, welche von der Kathodenseite her in die n-Basisschicht eingelassen ist;
(c) in dem Halbleitersubstrat zwischen der Anode und der Kathode eine Vielzahl von nebeneinander angeordneten, elektrisch parallel geschalteten Einheitszellen; und
(d) innerhalb jeder Einheitszelle ein auf der Kathodenseite angeordneter, erster MOSFET, welcher zum Abschalten des Bauelements vorgesehen ist;

Ein solches Bauelement ist z.B. aus einem Artikel von V. A. K. Temple, IEEE Transactions on Electron Devices, Vol. ED-33, No. 10, October 1986, S.1609-1618 als MOS-gesteuerter Thyristor (MCT) bekannt.

Die Erfindung betrifft weiterhin ein Verfahren zur Herstellung eines solchen Bauelements.

### STAND DER TECHNIK

Die moderne Leistungselektronik fordert heute schnelle, mit einfachen Mitteln ansteuerbare Halbleiterbauelemente, die bis zu den höchsten Leistungsbereichen einsetzbar sind.

Steuerbare Halbleiterbauelemente für höchste Leistungen sind heute die GTO(Gate Turn Off)-Thyristoren. Im Prinzip unterteilt man beim GTO die gesamte Chipfläche in eine Vielzahl von parallel geschalteten Elementarzellen. Ueber den Gatekontakt können diese Bauelemente ein- und ausgeschaltet werden; wegen der hohen Gateströme beim Abschalten ist dabei allerdings ein enormer Schaltungsaufwand für die Gateansteuerung in Kauf zu nehmen.

Seit einigen Jahren ist in der Leistungselektronik daher zunehmend die Entwicklung von MOS-gesteuerten Bauelementen vorangetrieben worden. Der Vorteil dieser MOS-gesteuerten Bauelemente liegt hauptsächlich in der hohen Eingangsimpedanz an der Steuerelektrode. Sie ermöglicht die Ansteuerung des Bauelements mit einem vergleichsweise sehr geringen Aufwand an Leistung.

Eingeleitet wurde dieser Trend von den unipolaren Leistungs-MOSFETs mit DMOS-Struktur. Diese DMOSFETs haben jedoch einen gewichtigen Nachteil: Hohe Durchbruchspannungen müssen bei diesen Bauelementen wegen des unipolaren Leitungscharakters mit hohen Durchlasswiderständen erkauft werden, welche die maximale Stromstärke begrenzen.

Höhere schaltbare Leistungen sind bekanntermassen nur mit Bipolarstrukturen (z.B. Thyristoren) erreichbar. Dennoch soll bei derartigen Bipolarstrukturen möglichst an der einfachen und insbesondere leistungsarmen Steuerung, welche man bei den Leistungs-MOSFETs verwendet, festhalten werden.

Es ist deshalb vorgeschlagen worden, das beschriebene Konzept der Steuerung von Leistungshalbleiter-Bauelementen über MOS-Gates auch bei Bauelementen der höchsten Leistungsklasse, nämlich bei Thyristoren, zu verwirklichen (siehe dazu den eingangs genannten Artikel von V. A. K. Temple).

Bei einem derartigen MOS-gesteuerten Thyristor oder MCT (MOS Controlled Thyristor), der wie der GTO aus einer Vielzahl von nebeneinanderliegenden, parallelgeschalteten Einheitszellen besteht, wird das Abschalten über einen Kurzschluss des Emitters mit der p-Basis durch schaltbare Emittershorts erreicht. Als Schalter dienen dabei mit dem Emitter integrierte MOSFETs, die naturgemäss wahlweise als n- oder p-Kanal-MOSFETs ausgebildet sein können.

Bei feinstrukturierten Thyristoren vom Typ des MCT oder GTO können allerdings während des Abschaltens extrem inhomogene Stromdichteverteilungen (Filamente) auftreten (siehe dazu: K. Lilja und H. Grüning, "Onset of Current Filamentation in GTO Devices", PESC '90, Power Electronics Specialist Conference, S.398-406 (1990)). Dabei führt ein kleiner Spannungszuwachs in der p-Basisschicht zu einem exponentiellen Anwachsen der Elektroneninjektion von der Kathode. Es kommt dadurch unter normalen Bedingungen zwangsläufig zu einer Umverteilung und Filamentierung des Stromes, die das Bauelement zerstören kann.

Zur Vermeidung von Filamentierungs-Effekten ist in dem älteren Schweizerischen Patentgesuch Nr. 03 783/90-3 (EP-A-487869) bereits ein Bauelement vorgeschlagen worden, bei welchem zwischen der Anode und der Kathode anstelle der üblichen bipolaren, aus vier Schichten bestehenden p-n-p-n-Thyristorstruktur nunmehr eine Fünfschicht-Struktur vorgesehen ist, wobei als fünfte Schicht auf der Kathodenseite ein direkt mit der Kathode verbundenes, p⁺-dotiertes p-Kurzschlussgebiet (dort "Kontaktgebiet" genannt) angeordnet ist.

Im Durchlassbetrieb wird das p-Kurzschlussgebiet durch einen MOSFET überbrückt. Beim Abschalten dagegen liegt diese zusätzliche Schicht zwischen der Kathode und der p-n-p-n-Thyristorstruktur und verhindert wirksam die zur Filamentierung führende Elektroneninjektion.

Problematisch ist bei der Herstellung dieses vorgeschlagenen Bauelements jedoch die genaue Plazierung der verschiedenen, unterschiedliche dotierten und ineinander eingelassenen Gebiete und Schichten. Wünschenswert wäre daher die Anwendbarkeit eines selbstjustierenden Verfahrens.

Ein weiteres Bauelement ist in dem Dokument EP-A-454201 beschrieben, bei welchem eine Fünfschicht-Struktur vorgesehen ist. Die einzige Gateelektrode befindet sich innerhalb eines Grabens und übernimmt sowohl das Einschalten als auch das Ausschalten dieses Bauelements.

### DARSTELLUNG DER ERFINDUNG

Es ist nun Aufgabe der Erfindung, ein bipolares, durch ein isoliertes Gate steuerbares Leistungshalbleiter-Bauelement zu schaffen, welches frei von Filamentierungs-Effekten höchste Leistungen zu schalten vermag und zugleich mit der notwendigen Präzision hergestellt werden kann, sowie ein Verfahren zu dessen Herstellung anzugeben.

Die Aufgabe wird bei einem Bauelement der eingangs genannten Art dadurch gelöst, dass innerhalb jeder Einheitszelle
(e) von der Kathodenseite her in die p-Basisschicht ein n⁺-dotiertes Abschaltgebiet, in das Abschaltgebiet seinerseits ein p⁺-dotiertes p-Kurzschlussgebiet, und in das p-Kurzschlussgebiet seinerseits ein n⁺-dotiertes erstes Kathodengebiet eingelassen sind, wobei das p-Kurzschlussgebiet und das erste Kathodengebiet auf der zweiten Hauptoberfläche mit einem Kathodenkontakt versehen sind;
(f) auf der einen Seite des Abschaltgebiets von der Kathodenseite her in die p-Basisschicht ein n⁺⁺-dotiertes zweites Kathodengebiet eingelassen ist, welches an das Abschaltgebiet angrenzt;
(g) auf der Kathodenseite über dem Halbleitersubstrat isoliert und nebeneinander eine erste und zweite Gateelektrode angeordnet und durch ein erstes Fenster voneinander getrennt sind, wobei
   (aa) die erste Gateelektrode den auf der einen Seite des Abschaltgebiets zwischen dem ersten Kathodengebiet und dem zweiten Kathodengebiet an die zweite Hauptoberfläche tretenden Teil des p-Kurzschlussgebietes überdeckt und zusammen mit diesen Gebieten den ersten MOSFET bildet; und
   (bb) die zweite Gateelektrode den auf der anderen Seite des Abschaltgebiets zwischen dem p-Kurzschlussgebiet und der p-Basisschicht an die zweite Hauptoberfläche tretenden Teil des Abschaltgebiets überdeckt und zusammen mit diesen Gebieten bzw. der Schicht einen zweiten MOSFET bildet; und
(h) das p-Kurzschlussgebiet und das Abschaltgebiet durch das erste Fenster in das Halbleitersubstrat eingebracht worden sind.

Das erfindungsgemässe Verfahren zeichnet sich dadurch aus, dass
(a) zunächst in ein n⁻-dotiertes, die n-Basisschicht bildendes Halbleitersubstrat von der zweiten Hauptoberfläche her die p-Basisschicht eingebracht wird;
(b) dann die zweite Hauptoberfläche des Halbleitersubstrats ganzflächig mit einer isoliert aufgebauten Gateelektrodenschicht bedeckt wird;
(c) dann in der Gateelektrodenschicht die ersten Fenster geöffnet werden, welche in der Gateelektrodenschicht die ersten und zweiten Gateelektroden voneinander trennen; und
(d) schliesslich durch die ersten Fenster nacheinander die Abschaltgebiete und die p-Kurzschlussgebiete in die darunterliegende p-Basisschicht eingelassen werden.

Der Kern der Erfindung besteht darin, zwischen der Anode und der Kathode anstelle der üblichen bipolaren, aus vier Schichten bestehenden p-n-p-n-Thyristorstruktur nunmehr eine Fünfschicht-Struktur vorzusehen, wobei als fünfte Schicht auf der Kathodenseite ein direkt mit der Kathode verbundenes, p⁺-dotiertes p-Kurzschlussgebiet angeordnet ist. Abschaltgebiet und p-Kurzschlussgebiet sind dabei selbstjustierend durch ein erstes Fenster zwischen erster und zweiter Gateelektrode in das Halbleitersubstrat eingebracht.

Im Durchlassbetrieb wird das p-Kurzschlussgebiet durch einen ersten MOSFET überbrückt. Die Injektion erfolgt dabei durch ein neben dem Abschaltgebiet angeordneten zweiten Kathodengebiet. Beim Abschalten dagegen liegt das p-Kurzschlussgebiet als zusätzliche Schicht zwischen der Kathode und der p-n-p-n-Thyristorstruktur und verhindert wirksam die zur Filamentierung führende Elektroneninjektion.

Durch Einschalten eines zweiten MOSFET, welcher aus dem p-Kurzschlussgebiet, dem Abschaltgebiet, der p-Basisschicht und einer über der n-Emitterschicht angeordneten zweiten Gateelektrode gebildet wird, werden beim Abschalten die von der Anode injizierten Löcher abgeführt und damit wirksam ein Avalanche-Durchbruch zwischen dem p-Kurzschlussgebiet und dem Abschaltgebiet verhindert.

Ein erste bevorzugte Ausführungsform des erfindungsgemässen Bauelements zeichnet sich dadurch aus, dass
(a) bei benachbarten Einheitszellen die verschiedenen Gebiete und Gateelektroden jeweils spiegelbildlich angeordnet sind;
(b) die zweiten Gateelektroden von je zwei benachbarten Einheitszellen zu einer gemeinsamen zweiten Gateelektrode zusammengefasst sind;
(c) zwischen den zweiten Kathodengebieten von zwei benachbarten Einheitszellen die p-Basisschicht und die n-Basisschicht an die zweite Hauptoberfläche gezogen sind;
(d) über den an die zweite Hauptoberfläche tretenden Teilen der p-Basisschicht und der n-Basisschicht eine isolierte dritte Gateelektrode angeordnet ist, welche von den benachbarten ersten Gateelektroden jeweils durch ein zweites Fenster getrennt ist, durch welches zweite Fenster jeweils das zweite Kathodengebiet in das Halbleitersubstrat eingebracht worden ist; und
(e) das zweite Kathodengebiet die p-Basisschicht, die n-Basisschicht und die dritte Gateelektrode einen dritten MOSFET bilden, welcher eine schaltbare Verbindung zwischen der n-Basisschicht und dem Abschaltgebiet herstellt und zum Einschalten des Bauelements dient.

Weiter Ausführungsformen ergeben sich aus den Unteransprüchen.

### KURZE BESCHREIBUNG DER ZEICHNUNG

Die Erfindung soll nachfolgend im Zusammenhang mit der Zeichnung anhand von Ausführungsbeispielen näher erläutert werden. Es zeigen
- Fig. 1: im Querschnitt mehrere, paarweise spiegelbildlich angeordnete Einheitszellen eines Bauelements gemäss einer ersten bevorzugten Ausführungsform der Erfindung mit zwei MOSFETs;
- Fig. 2A: im Querschnitt die Einheitszelle eines Bauelements gemäss einer zweiten bevorzugten Ausführungsform der Erfindung mit drei MOSFETs, von denen der dritte zum Einschalten verwendet wird und jeweils zwischen den ersten MOSFETs zweier benachbarter Einheitszellen angeordnet ist;
- Fig. 2B: im Querschnitt die Einheitszelle einer mit Fig. 2A vergleichbaren Ausführungsform, bei welcher der zweite MOSFET durch ein zusätzliches Kanal-Implantationsgebiet in einen Verarmungstyp umgewandelt worden ist;
- Fig. 2C: eine beispielhafte Anordnung der verschiedenen Gateelektroden bei einem Bauelement gemäss Fig. 2A, wobei die Anzahl der dritten MOSFETs nur halb so gross ist wie die Anzahl der Einheitszellen;
- Fig. 3: im Querschnitt die Einheitszelle einer weiteren bevorzugten Ausführungsform des erfindungsgemässen Bauelements mit drei MOSFETs, bei welcher Ausführungsform die zweite Gateelektrode zugleich als Gateelektrode des dritten MOSFET eingesetzt ist;
- Fig. 4A-F: verschiedene Stufen bei der Herstellung eines Bauelements gemäss Fig. 2A nach einer bevorzugten Ausführungsform des erfindungsgemässen Verfahrens;
- Fig. 5: im Querschnitt die Einheitszelle einer zu Fig. 2A analogen Ausführungsform des erfindungsgemässen Bauelements, bei der zusätzlich auf der Anodenseite Shorts vorgesehen sind; und
- Fig. 6A-E: die verschiedenen Verläufe der Dotierungskonzentration entlang den in Fig. 5 eingezeichneten Schnitten A-A bis E-E.

### WEGE ZUR AUSFÜHRUNG DER ERFINDUNG

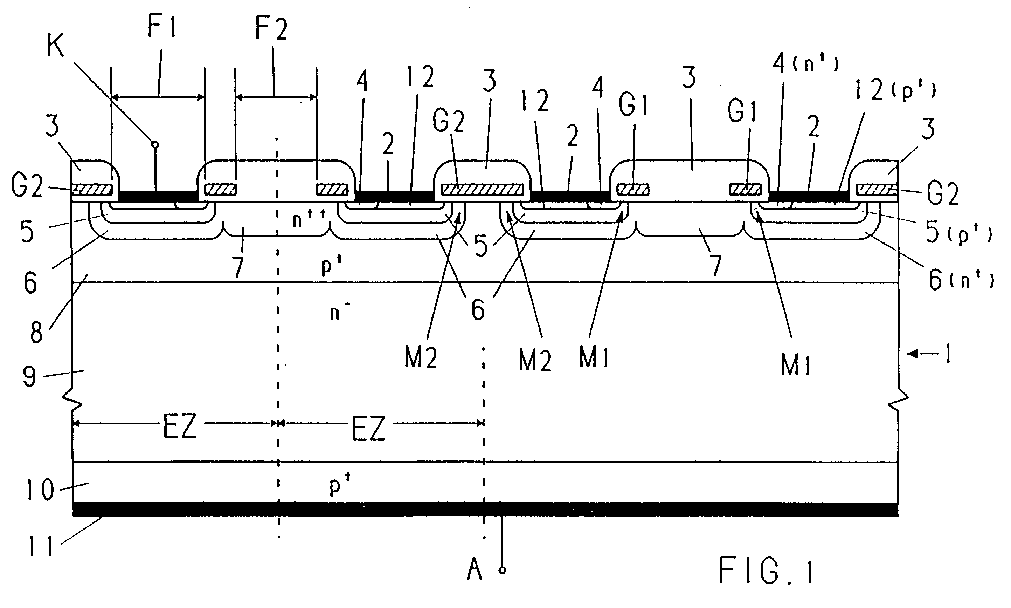

In Fig. 1 sind im Querschnitt mehrere jeweils spiegelbildlich zueinander angeordneter Einheitszelle EZ einer bevorzugten Ausführungsform des Bauelements nach der Erfindung dargestellt. Das Bauelement ist generell ein fünf Schichten umfassender, über ein isoliertes Gate gesteuerter, bipolarer Schalter und soll daher nachfolgend kurz als IG-FiBS (Insulated Gate controlled Five layer Bipolar Switch) bezeichnet werden.

In der gezeigten Ausführungsform besteht der IG-FiBS aus einem Halbleitersubstrat 1 mit einer ersten (unteren) und einer zweiten (oberen) Hauptoberfläche. Die erste Hauptoberfläche ist mit einem (metallischen) Anodenkontakt 11 versehen, der mit der Anode A in Verbindung steht. Die zweite Hauptoberfläche trägt innerhalb jeder Einheitszelle einen (metallischen) Kathodenkontakt 2, der seinerseits mit der Kathode K in Verbindung steht.

Zwischen dem Anodenkontakt 11 und dem Kathodenkontakt 2 ist innerhalb des Halbleitersubstrats 1 eine Schichtenfolge von fünf mit wechselnder Polarität dotierten Schichten angeordnet, welche aufeinanderfolgend eine p⁺-dotierte Anodenschicht 10, eine n⁻-dotierte n-Basisschicht 9, eine p⁺-dotierte p-Basisschicht 8, ein in die p-Basissschicht 8 eingelassenes, n⁺-dotiertes Abschaltgebiet 6 und ein in das Abschaltgebiet 6 eingelassenes, p⁺-dotiertes p-Kurzschlussgebiet 5 umfasst. Die Anodenschicht 10 wird dabei von dem Anodenkontakt 11 kontaktiert; das p-Kurzschlussgebiet 5 bzw. ein zur Verbesserung des Kontaktes zusätzlich in das p-Kurzschlussgebiet 5 eingelassenes, p⁺-dotiertes Kontaktgebiet 12, werden auf der anderen Seite des Halbleitersubstrats 1 vom Kathodenkontakt 2 kontaktiert.

Seitwärts vom Kathodenkontakt 2 ist in jeder Einheitszelle EZ auf der einen Seite ein erster MOSFET M1 und auf der anderen Seite ein zweiter MOSFET M2 in das Halbleitersubstrat 1 integriert.

Der erste MOSFET M1 wird aus einem in das p-Kurzschlussgebiet 5 eingelassenen, mit dem Kathodenkontakt 2 verbundenen, n⁺-dotierten, ersten Kathodengebiet 4, dem p-Kurzschlussgebiet 5, dem Abschaltgebiet 6 bzw. einem daran angrenzenden, n⁺⁺-dotierten, zweiten Kathodengebiet 7, und einer oberhalb des p-Kurzschlussgebietes 5 isoliert (Gateisolierung 3) angeordneten ersten Gateelektrode G1 gebildet. Er ist in diesem Fall ein n-Kanal-MOSFET, dessen Kanalgebiet Teil des zwischen Abschaltgebiet 6 und erstem Kathodengebiet 4 an die zweite Hauptoberfläche tretenden p-Kurzschlussgebietes 5 ist.

Der zweite MOSFET M2 wird aus der an die zweite Hauptoberfläche tretenden p-Basisschicht 8, dem Abschaltgebiet 6, dem p-Kurzschlussgebiet 5 und einer oberhalb des Abschaltgebiets 6 isoliert (Gateisolierung 3) angeordneten zweiten Gateelektrode G2 gebildet. Er ist in diesem Fall ein p-Kanal-MOSFET, dessen Kanalgebiet Teil des zwischen dem wannenförmigen p-Kurzschlussgebiet 5 und der p-Basisschicht 8 an die zweite Hauptoberfläche tretenden Abschaltgebiets 6 ist.

Man erkennt in der Darstellung der Fig. 1, dass die Einheitszellen in dieser Ausführungsform paarweise spiegelbildlich zueinander angeordnet sind, wobei jede Einheitszelle EZ mit der auf der einen Seite benachbarten Einheitszelle eine gemeinsame zweite Gatelektrode G2, und mit der auf der anderen Seite benachbarten Einheitszelle ein gemeinsames zweites Kathodengebiet 7 teilen. Auf diese Weise werden zwischen der ersten und zweiten Gateelektrode G1 bzw. G2 jeder Einheitszelle EZ jeweils ein erstes Fenster F1, und zwischen den ersten Gateelektroden G1 benachbarter Einheitszellen jeweils ein zweites Fenster F2 gebildet. Durch die ersten Fenster F1 können in selbstjustierender Weise nacheinander das Abschaltgebiet 6 und das p-Kurzschlussgebiet 5 in die bereits vorhandene p-Basisschicht 8 eingebracht werden. Durch die zweiten Fenster F2 wird entsprechend das zweite Kathodengebiet 7 eingebracht. Die Gateelektroden und die dazwischenliegenden Fenster wirken dabei von Anfang an als Masken für die verschiedenen Implantationen.

Das Bauelement gemäss Fig. 1 kann in einem Ersatzschaltbild als antiparallele Serieschaltung aus einer Diode und einem Thyristor aufgefasst werden, wobei die Diode durch den ersten MOSFET M1 überbrückt werden kann, während der zweite MOSFET M2 zwischen die Kathode und das Gate des Thyristors geschaltet ist.

Die Funktion des Bauelements gemäss Fig. 1 ist die folgende: Im eingeschalteten Zustand (ON-State) hat die erste Gateelektrode G1 relativ zur Kathode K eine positive Gatespannung. Der erste MOSFET M1 ist damit eingeschaltet und schliesst den Kathodenkontakt 2 mit dem Abschaltgebiet 6 und dem angrenzenden zweiten Kathodengebiet 7 kurz. Ein besonders gutes Durchlassverhalten ergibt sich dabei durch das stark n-dotierte zweite Kathodengebiet, das für das übrige Bauelement als effektiver Elektronen-Emitter wirkt. Durch den Kurzschluss reduziert sich die aktive Struktur des Bauelements auf eine p-n-p-n-Folge von vier Schichten (Anodenschicht 10, n-Basisschicht 9, p-Basisschicht 8 und zweites Kathodengebiet 7), die sich - abgesehen von dem Kanalwiderstand des ersten MOSFET, der sehr klein gemacht werden kann - wie ein herkömmlicher Thyristor verhält. Der zweite MOSFET M2 ist in dieser Phase gesperrt.

Um nun das Bauelement abzuschalten, wird die Gatespannung an der ersten Gateelektrode G1 reduziert, sodass der erste MOSFET M1 in den gesperrten Zustand übergeht. Hierdurch wird der IG-FiBS von der Vierschicht- in eine Fünfschicht(p-n-p-n-p)-Struktur überführt und schaltet ab. Es ist festzuhalten, dass durch das zusätzliche, p-dotierte Abschaltgebiet 5 die Elektroneninjektion von der Kathodenseite her grundsätzlich vollständig aufhört.

Gleichzeitig mit dem Sperren des ersten MOSFET M1 wird der zweite MOSFET M2 eingeschaltet, der dann den vollen Abschaltstrom übernimmt. Dies ist notwendig, um einen Avalanche-Durchbruch am PN-Uebergang zwischen dem p-Kurzschlussgebiet 5 und dem Abschaltgebiet 6 zu verhindern. Dieser PN-Uebergang hat nämlich eine ziemlich geringe Durchbruchspannung (in der Grössenordnung von 10-20 V), die weit unterhalb der Sperrfähigkeit des gesamten Bauelements liegt. Ein Avalanche-Durchbruch an diesem PN-Uebergang würde dann ein Abschalten des Bauelements verhindern oder zumindest den Abschaltprozess beträchtlich verlangsamen.

Unter Bezugnahme auf die Erklärungen der Strom-Umverteilung, wie sie für den GTO und den MCT in dem eingangs genannten Artikel von K. Lilja und H. Grüning gegeben worden sind, kann nun leicht erläutert werden, warum der IG-FiBS gemäss der Erfindung keine Probleme mit einer Filamentierung des Stromes hat: In einem GTO oder MCT führt eine geringe Zunahme der Spannung an der p-Basisschicht (entspricht der p-Basisschicht 8 in Fig. 1) während des Abschaltvorgangs zu einem exponentiellen Ansteigen der Elektroneninjektion von der Kathode K. Wie in dem zitierten Artikel beschrieben, zieht dies notwendigerweise eine Strom-Umverteilung und -Filamentierung nach sich (es sei denn, es gelte die spezielle Bedingung β_{eff} < β_{crit}).

In dem IG-FiBS dagegen wird beim Abschalten die Kathode durch das p-dotierte p-Kurzschlussgebiet 5 gebildet. Aus diesem Grunde ist eine Elektroneninjektion überhaupt nicht möglich. Vielmehr resultiert eine Zunahme des Stromes in der IG-FiBS-Struktur während des Abschaltens in einem schnelleren Abbau der gespeicherten Ladungsträger, d.h. in einem schnelleren Turn-Off. Der IG-FiBS ist daher selbst-stabilisierend.

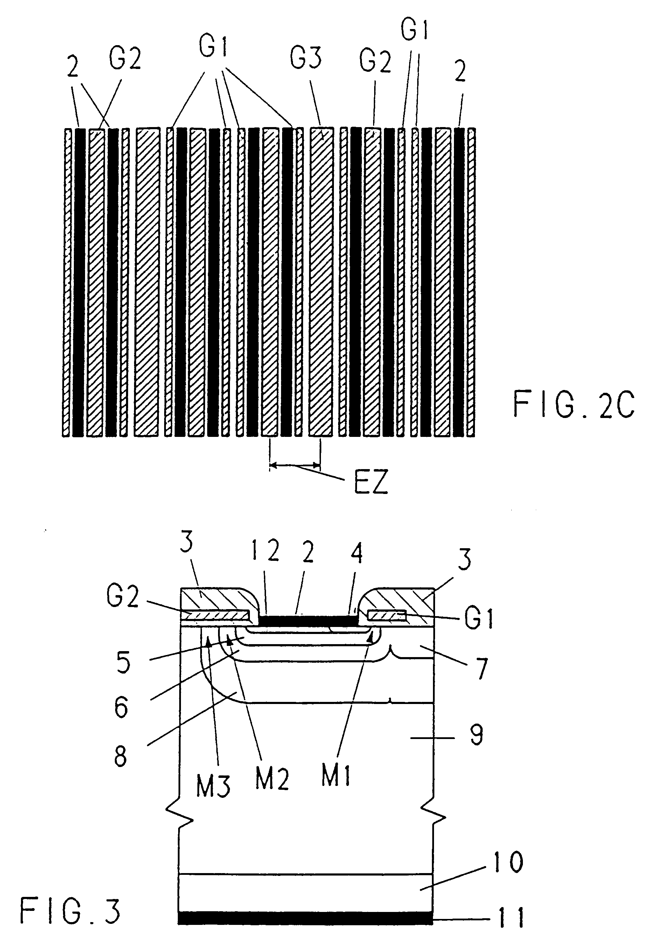

Die in Fig. 1 dargestellte Struktur umfasst die beiden MOSFETs M1 und M2, die beide - wie oben erläutert - für den Abschaltvorgang notwendig sind. Für das Einschalten des Bauelements kann dann an bestimmten Stellen des Bauelements ein dritter MOSFET M3 (Fig. 2A-C; Fig. 3) vorgesehen werden. Dieser dritte MOSFET M3 wird grundsätzlich durch die an die zweite Hauptoberfläche gezogene n-Basisschicht 9, die an die zweite Hauptoberfläche gezogene p-Basisschicht 8, das zweite Kathodengebiet 7 (Fig. 2A-C) bzw. das Abschaltgebiet 6 (Fig. 3), und eine zugehörige, über dem an die zweite Hauptoberfläche tretenden Teil der p-Basisschicht 8 isoliert angeordnete Gateelektrode gebildet.

Diese zugehörige Gateelektrode kann - wie in Fig. 2A-C gezeigt - eine separate dritte Gateelektrode G3 sein, die zwischen den ersten Gateelektroden G1 zweier benachbarter Einheitszellen EZ angeordnet ist. Insbesondere kann dabei die Anzahl der dritten MOSFETs M3 unabhängig von und kleiner als die Anzahl der Einheitszellen EZ gewählt werden, so dass z.B. - wie aus der in Fig. 2C dargestellten beispielhaften Anordnung der Gateelektroden abgelesen werden kann - nur ein dritter MOSFET M3 (Gateelektrode G3) auf je zwei Einheitszellen EZ kommt. Die erste und die dritte Gateelektrode G1 bzw. G3 sind dann durch ein drittes Fenster F3 (Fig. 2A) voneinander getrennt, durch welches das zweite Kathodengebiet 7 (einzeln für jede Einheitszelle EZ) selbstjustierend in die p-Basisschicht 8 eingebracht werden kann.

Die Funktion der weiteren Gateelektrode kann aber auch - wie in Fig. 3 dargestellt - von der zweiten Gateelektrode G2 mit übernommen werden. Ein solches Bauelement geht aus der in Fig. 1 gezeigten Ausführungsform dadurch hervor, dass unter bestimmten oder allen zweiten Gateelektroden G2 auch die n-Basisschicht 9 an die zweite Hauptoberfläche des Halbleitersubstrats 1 geführt wird.

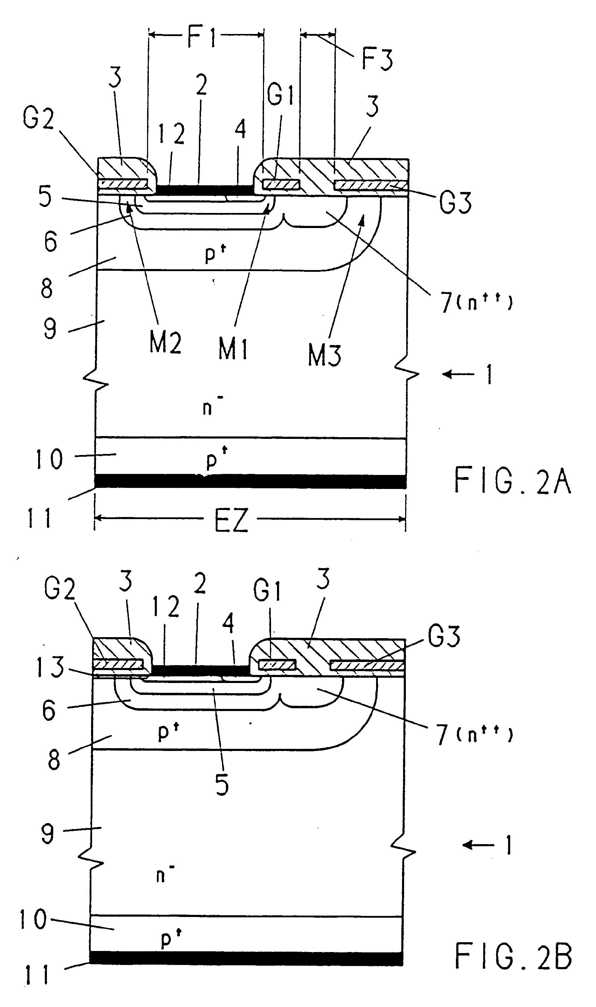

Während in den Ausführungsformen der Figuren 2A und 3 zur Konfiguration der MOSFETs M1 und M2 nur die fünf ohnehin vorhandenen Schichten und Gebiete verwendet werden, können bei einem dieser MOSFETs oder auch bei beiden von der zweiten Hauptoberfläche her zusätzlich Kanal-Implantationsgebiete (13 beim MOSFET M2 in Fig. 2B) vorgesehen werden, mit deren Hilfe die Schwellspannungen der MOSFETs einjustiert werden können. Im Falle des Bauelements aus Fig. 2B wandelt das p-leitende Kanal-Implantationsgebiet 13 den zweiten MOSFET M2 von einem Normally-Off- in einen Normally-On-MOSFET (MOSFET vom Verarmungs-Typ) um.

Der Betrieb und insbesondere die Ansteuerung der Bauelemente gemäss Figuren 2A-C und 3 kann auf unterschiedliche Weisen erfolgen:

### Alternative 1:

Bei dieser Alternative ist die zweite Gateelektrode G2 des zweiten MOSFETs M2 direkt mit der Kathode K kurzgeschlossen und ist deshalb auf dem Potential Null. Die Gates der MOSFETs M1 und M3 werden dann mit einer externen Gatespannung angesteuert, die für beide MOSFETs gleich ist.

Das Bauelement sei zunächst im On-Zustand, wobei die Gatespannung der MOSFETs M1 und M3 einen positiven Wert (z.B. 10 V) annimmt. M1 und M3 sind daher beide eingeschaltet und der FiBS verhält sich wie ein Thyristor, der mit einem fortlaufenden Zündstrom beaufschlagt ist. Wenn nun diese Gatespannung reduziert wird (z.B. von den +10 V auf 0 V), beginnen M1 und M3 abzuschalten. Der FiBS wird dann in eine 5-Schicht-Struktur überführt und beginnt ebenfalls abzuschalten. Damit steigt die an dem sperrenden Uebergang zwischen Abschaltgebiet 6 und p-Kurzschlussgebiet 5 abfallende Spannung. Als Folge davon wird die Spannung des Abschaltgebiets 6 positiv gegenüber der Gatespannung des zweiten MOSFETs M2. Dieser MOSFET wird daher automatisch einschalten und den Löcherstrom, der von der Kathode K kommt, übernehmen. Der FiBS kann dann - wie bereits vorher beschrieben - ohne Probleme der Stromverteilung oder Filamentierung abschalten, da eine Elektronen-Injektion von der Kathode her sicher unterbunden ist.

Um das Bauelement einzuschalten, wird die Gatespannung erneut angehoben. M1 und M3 schalten dann ein und der FiBS wird erneut in einen Thyristor umgewandelt, der durch den dritten MOSFET M3 gezündet wird und natürlich einschaltet. Da die Elektronen-Injektion von der Kathode durch den im MOSFET M1 fliessenden Strom begrenzt wird, ist die Stromverteilung auch im Einschalt-Zustand beim FiBS sehr viel homogener als beim GTO oder MCT.

### Alternative 2:

Die Gateelektroden G1 bis G3 aller drei MOSFETs M1 bis M3 werden mit derselben externen Gatespannung beaufschlagt. Im On-Zustand des FiBS wird diese Gatespannung auf einem positiven Wert (z.B. +10 V) gehalten. Zum Abschalten wird sie negativ gemacht (z.B. -10 V) und zum Einschalten wiederum positiv.

### Alternative 3:

Diese Alternative ist weitgehend identisch mit der Alternative 2, bis auf den Umstand, dass der zweite MOSFET M2 (sieh Fig. 2B) durch ein zusätzliches Kanal-Implantationsgebiet 13 in einen Normally-On-MOSFET umgewandelt worden ist, sodass eine Gatespannung von 0 V ausreicht, um das Bauelement abzuschalten und im Off-Zustand zu halten.

### Alternative 4:

In diesem Fall wird der zweite MOSFET M2 durch ein anderes Signal gesteuert als der erste MOSFET M1. Beim Abschalten geht die Gatespannung des MOSFET M1 von einem positiven Wert auf Null, und die Gatespannung des MOSFET M2 geht von Null auf einen negativen Wert. Der umgekehrte Ablauf ergibt sich für den Einschaltvorgang.

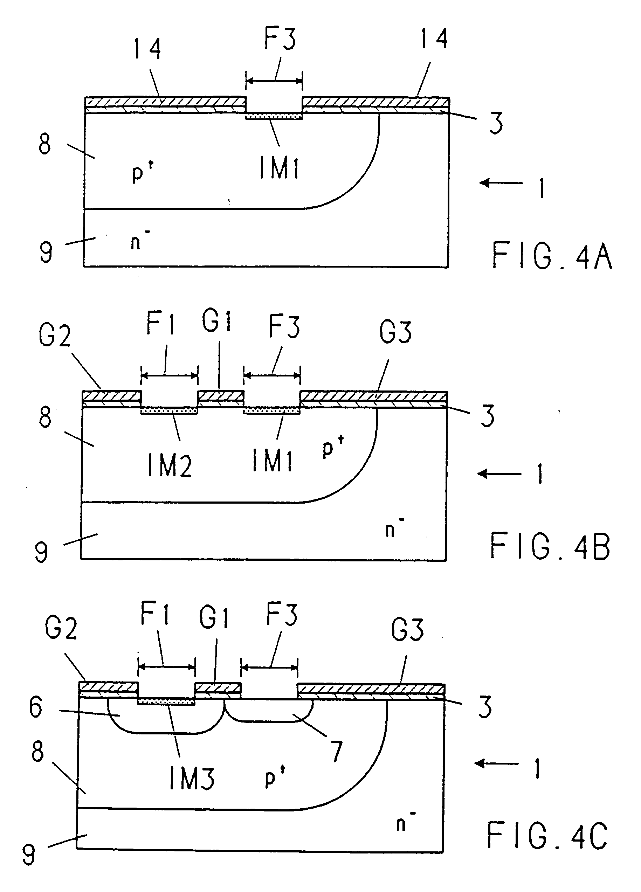

Wie bereits erwähnt worden ist, besteht ein wesentliches Merkmal der vorliegenden Erfindung in der weitgehend selbstjustierenden Herstellbarkeit der Bauelement-Struktur. Ausgewählte Schritte eines beispielhaften Herstellungsprozesses für ein Bauelement gemäss Fig. 2A , die diese Selbstjustierung verdeutlichen, sind in den Figuren 4A bis 4F für eine Einheitszelle EZ wiedergegeben. Die Darstellung beschränkt sich dabei der Einfachheit halber auf die kathodenseitige Struktur.

Bei der Herstellung wird ausgegangen von einem n⁻-dotierten Halbleitersubstrat 1, welches die n-Basisschicht 9 bildet. In die n-Basisschicht 9 werden nacheinander von der ersten Hauptoberfläche her die Anodenschicht 10, und von der zweiten Hauptoberfläche her die p-Basisschicht 8 eingebracht. Die zweite Hauptoberfläche wird dann mit der Gateisolierung 3 abgedeckt, auf die eine durchgehende Gateelektrodenschicht 14 aus Poly-Si aufgebracht wird (Fig. 4A). In dieser Gateelektrodenschicht 14 wird dann durch Photostrukturierung und Aetzen das dritte Fenster F3 geöffnet, durch welches eine erste Implantation IM1 für das spätere zweite Kathodengebiet 7 in das Halbleitersubstrat 1 eingebracht wird. Die Einheitszelle hat in diesem Stadium die in Fig. 4A dargestellte Konfiguration.

Neben dem dritten Fenster F3 wird anschliessend in der Gateelektrodenschicht 14 das erste Fenster F1 geöffnet. Die Gateelektrodenschicht 14 zerfällt dadurch in die späteren Gateelektroden G1, G2 und G3. Durch das erste Fenster F1 wird eine zweite Implantation IM2 für das spätere Abschaltgebiet 6 in das Halbleitersubstrat 1 eingebracht.

Die Einheitszelle hat in diesem Stadium die in Fig. 4B gezeigte Konfiguration.

Ein daran anschliessendes Drive-In bildet bereits in einer ersten Stufe das Abschaltgebiet 6 und das zweite Kathodengebiet 7 aus, sodass dann durch das erste Fenster F1 eine dritte Implantation IM3 für das spätere p-Kurzschlussgebiet 5 in das Abschaltgebiet 6 eingebracht werden kann. Die Einheitszelle hat in diesem Stadium die in Fig. 4C gezeigte Konfiguration.

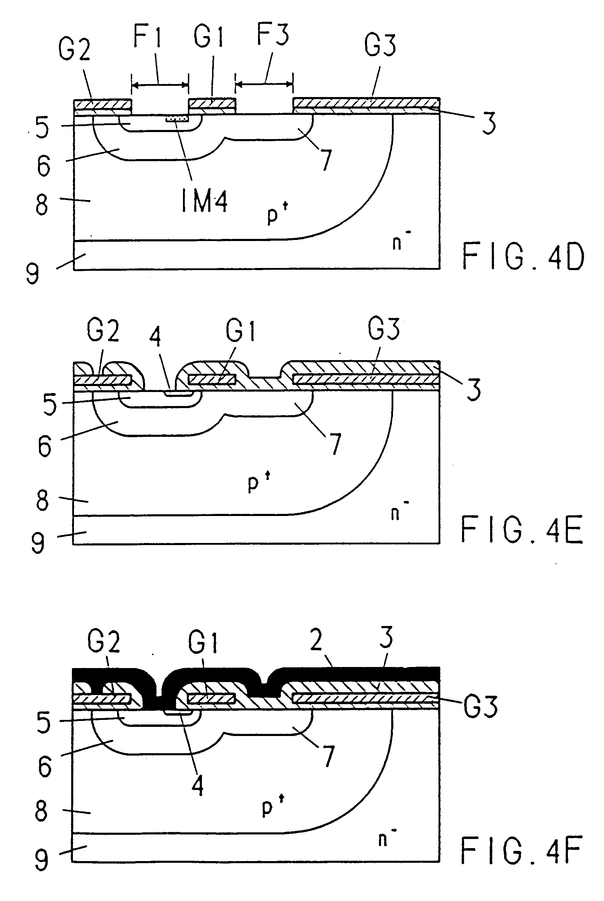

Ein weiteres Drive-In bildet die Gebiete 6 und 7 weiter aus und lässt das p-Kurzschlussgebiet 5 entstehen. Mit Hilfe einer (nicht dargestellten) zusätzlichen Maske wird dann das erste Fenster F1 teilweise abgedeckt und innerhalb des ersten Fensters F1 eine in der Breite begrenzte vierte Implantation IM4 für das spätere erste Kathodengebiet 4 in das p-Kurzschlussgebiet 5 eingebracht. Die zusätzliche Maske wird anschliessend wieder entfernt. Die Einheitszelle hat in diesem Stadium die in Fig. 4D wiedergegebene Konfiguration.

Ein abschliessendes Drive-In bildet dann das erste Kathodengebiet 4 aus. Danach werden die Gateelektroden G1, G2 und G3 durch die Gateisolierung 3 vollständig abgedeckt und zwei Oeffnungen für die Kontaktierung der zweiten Gateelektrode G2 und den Kathodenanschluss in die Gateisolierung 3 geätzt (Fig. 4E). Schliesslich wird ein durchgehender Kathodenkontakt 2 auf der Gateisolierung 3 abgeschieden, der durch die beiden Oeffnungen gleichzeitig die zweite Gateelektrode G2, das erste Kathodengebiet 4 und das p-Kurzschlussgebiet 5 kontaktiert (Fig. 4F). Die Gateelektrode G2 ist damit bei dieser Ausführungsform gemäss der oben erläuterten Ansteuerungs-Alternative 1 direkt mit der Kathode K verbunden.

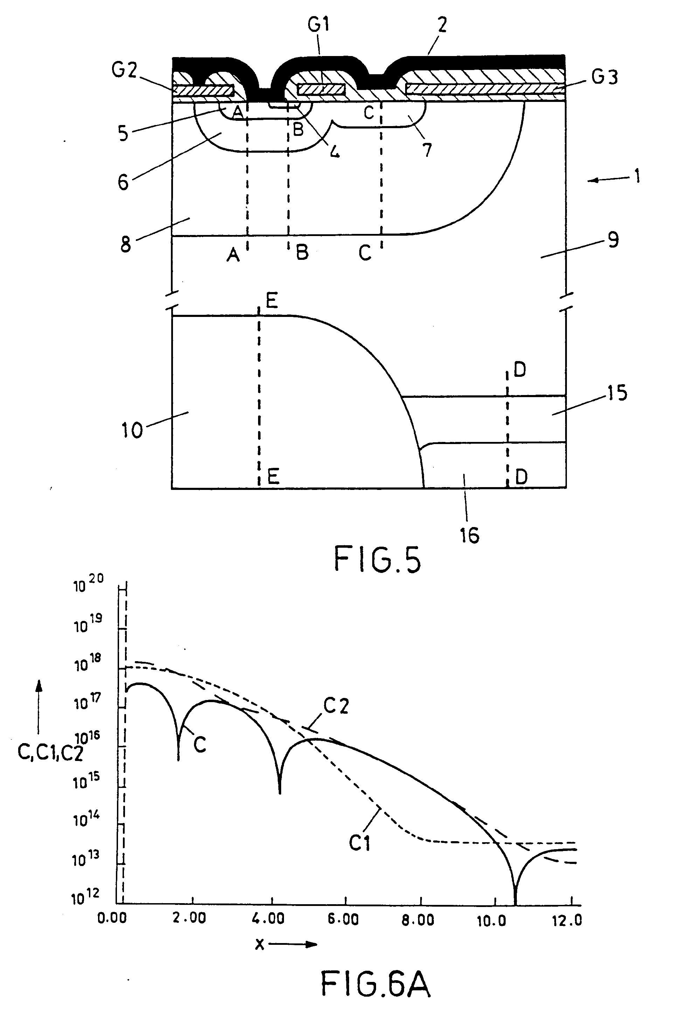

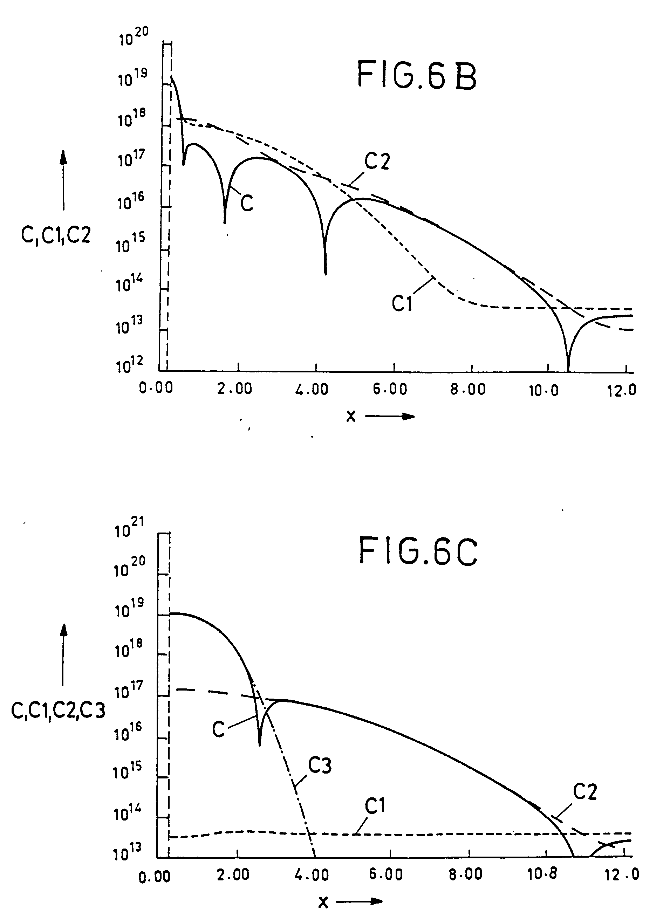

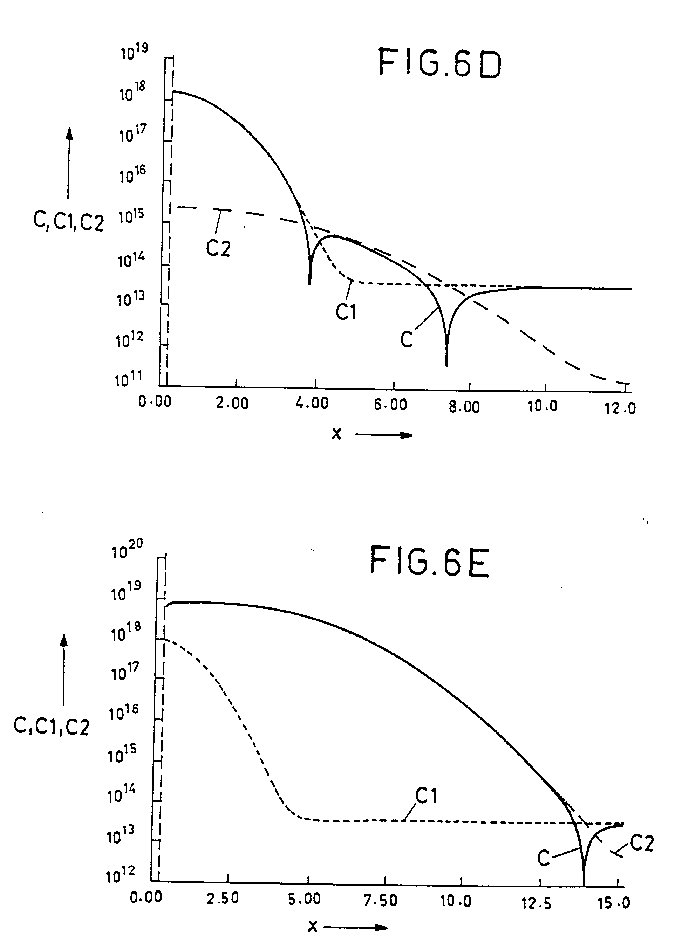

Die vollständige Einheitszelle des bei diesem Prozess entstehenden Bauelements hat die in Fig. 5 dargestellte Struktur. Auf der Anodenseite sind in diesem Fall ein zusätzliches n-Kurzschlussgebiet 16 (Anodenshort) und eine zwischen n-Kurzschlussgebiet 16 und n-Basisschicht 9 angeordnete p-Zone vorgesehen (siehe dazu z.B. die EP-A1-0 327 901). Beispielhafte Verläufe der Dotierungskonzentrationen entlang der in Fig. 5 strichliert eingezeichneten Schnittlinien A-A bis E-E sind entsprechend in den Fig. 6A bis 6E wiedergegeben. "x" bezeichnet dabei die von der jeweiligen Hauptoberfläche gemessene Tiefe in »m, "c" die gesamte Dotierungskonzentration (in cm⁻³), "c1" die Konzentration von P, "c2" die Konzentration von B, und "c3" die Konzentration von As (alle in cm⁻³).

Die bisherigen Ausführungen haben sich auf ein Bauelement mit p-n-p-n-p-Schichtenfolge bezogen, bei welcher die einzelnen Schichten und Gebiete eine Dotierung eines bestimmten Typs aufweisen. Es liegt aber auch im Rahmen der Erfindung, alle Schichten 8, 9 und 10 und Gebiete 4, 5, 6, 7, 12 innerhalb des Halbleitersubstrats 1 durch entsprechende Schichten und Gebiete mit komplementärer Dotierung zu ersetzen; die p⁺-dotierte Anodenschicht 10 wird dann umgewandelt in eine n⁺-dotierte n-Emitterschicht, die n-dotierte n-Basisschicht 9 in eine p-dotierte p-Basisschicht, usw..

Insgesamt ergibt sich mit der Erfindung ein leicht ansteuerbares, sicher abschaltbares Hochleistungs-Bauelement, bei welchem eine Filamentierung des Stromes beim Abschalten vermieden wird, und welches sich vergleichsweise einfach und mit hoher Präzision herstellen lässt.

## Patentansprüche

1. Abschaltbares Leistungshalbleiter-Bauelement, umfassend
(a) ein flächiges Halbleitersubstrat (1) mit zwei gegenüberliegenden Hauptoberflächen, von denen die erste als Anode (A) und die zweite als Kathode (K) ausgebildet ist;
(b) in dem Halbleitersubstrat (1) zwischen der Anode (A) und der Kathode (K) eine lateral durchgehende, n⁻-dotierte n-Basisschicht (9), eine p⁺-dotierte Anodenschicht (10), welche von der Anodenseite her in die n-Basisschicht (9) eingelassen und auf der ersten Hauptoberfläche mit einem Anodenkontakt (11) versehen ist, und eine p⁺-dotierte p-Basisschicht (8), welche von der Kathodenseite her in die n-Basisschicht (9) eingelassen ist;
(c) in dem Halbleitersubstrat (1) zwischen der Anode (A) und der Kathode (K) eine Vielzahl von nebeneinander angeordneten, elektrisch parallel geschalteten Einheitszellen (EZ); und
(d) innerhalb jeder Einheitszelle (EZ) ein auf der Kathodenseite angeordneter, erster MOSFET (M1), welcher zum Abschalten des Bauelements vorgesehen ist;
dadurch gekennzeichnet, dass innerhalb jeder Einheitszelle (EZ)
(e) von der Kathodenseite her in die p-Basisschicht (8) ein n⁺-dotiertes Abschaltgebiet (6), in das Abschaltgebiet (6) seinerseits ein p⁺-dotiertes p-Kurzschlussgebiet (5), und in das p-Kurzschlussgebiet (5) seinerseits ein n⁺-dotiertes erstes Kathodengebiet (4) eingelassen sind, wobei das p-Kurzschlussgebiet (5) und das erste Kathodengebiet (4) auf der zweiten Hauptoberfläche mit einem Kathodenkontakt (2) versehen sind;
(f) auf der einen Seite des Abschaltgebiets (6) von der Kathodenseite her in die p-Basisschicht (8) ein n⁺⁺-dotiertes zweites Kathodengebiet (7) eingelassen ist, welches an das Abschaltgebiet (6) angrenzt;
(g) auf der Kathodenseite über dem Halbleitersubstrat (1) isoliert und nebeneinander eine erste und zweite Gateelektrode (G1 bzw. G2) angeordnet und durch ein erstes Fenster (F1) voneinander getrennt sind, wobei
(aa) die erste Gateelektrode (G1) den auf der einen Seite des Abschaltgebiets (6) zwischen dem ersten Kathodengebiet (4) und dem zweiten Kathodengebiet (7) an die zweite Hauptoberfläche tretenden Teil des p-Kurzschlussgebietes (5) überdeckt und zusammen mit diesen Gebieten den ersten MOSFET (M1) bildet; und
(bb) die zweite Gateelektrode (G2) den auf der anderen Seite des Abschaltgebiets (6)zwischen dem p-Kurzschlussgebiet (5) und der p-Basisschicht (8) an die zweite Hauptoberfläche tretenden Teil des Abschaltgebiets (6) überdeckt und zusammen mit diesen Gebieten bzw. der Schicht einen zweiten MOSFET (M2) bildet; und
(h) das p-Kurzschlussgebiet (5) und das Abschaltgebiet (6) durch das erste Fenster (F1) in das Halbleitersubstrat (1) eingebracht worden sind.

2. Bauelement nach Anspruch 1, dadurch gekennzeichnet, dass
(a) bei benachbarten Einheitszellen (EZ) die verschiedenen Gebiete (4,5,6,7) und Gateelektroden (G1,G2) jeweils spiegelbildlich angeordnet sind; und
(b) die zweiten Gateelektroden (G2) von je zwei benachbarten Einheitszellen (EZ) zu einer gemeinsamen zweiten Gateelektrode zusammengefasst sind.

3. Bauelement nach Anspruch 2, dadurch gekennzeichnet, dass
(a) die zweiten Kathodengebiete (7) von je zwei benachbarten Einheitszellen (EZ) zu einem gemeinsamen zweiten Kathodengebiet zusammengefasst sind; und
(b) die ersten Gateelektroden (G1) dieser benachbarten Einheitszellen (EZ) durch ein zweites Fenster (F2) voneinander getrennt sind, durch welches zweite Fenster (F2) das gemeinsame zweite Kathodengebiet in das Halbleitersubstrat (1) eingebracht worden ist.

4. Bauelement nach Anspruch 3, dadurch gekennzeichnet, dass
(a) innerhalb bestimmter Einheitszellen (EZ) auf der Kathodenseite ein dritter MOSFET (M3) zum Einschalten des Bauelements vorgesehen ist;
(b) der dritte MOSFET (M3) eine schaltbare Verbindung zwischen der n-Basisschicht (9) und dem Abschaltgebiet (6) herstellt; und
(c) der dritte MOSFET (M3) aus der unterhalb der zweiten Gateelektrode (G2) an die zweite Hauptoberfläche gezogenen n-Basisschicht (9), der angrenzenden p-Basisschicht (8), dem Abschaltgebiet (6) und der zweiten Gateelektrode (G2) gebildet wird.

5. Bauelement nach Anspruch 2, dadurch gekennzeichnet, dass
(a) zwischen den zweiten Kathodengebieten (7) von zwei benachbarten Einheitszellen (EZ) die p-Basisschicht (8) und die n-Basisschicht (9) an die zweite Hauptoberfläche gezogen sind;
(b) über den an die zweite Hauptoberfläche tretenden Teilen der p-Basisschicht (8) und der n-Basisschicht (9) eine isolierte dritte Gateelektrode (G3) angeordnet ist, welche von den benachbarten ersten Gateelektroden (G1) jeweils durch ein drittes Fenster (F3) getrennt ist, durch welches dritte Fenster (F3) jeweils das zweite Kathodengebiet (7) in das Halbleitersubstrat (1) eingebracht worden ist; und
(c) das zweite Kathodengebiet (7) die p-Basisschicht (8), die n-Basisschicht (9) und die dritte Gateelektrode (G3) einen dritten MOSFET (M3) bilden, welcher eine schaltbare Verbindung zwischen der n-Basisschicht (9) und dem Abschaltgebiet (6) herstellt und zum Einschalten des Bauelements dient.

6. Bauelement nach einem der Ansprüche 4 und 5, dadurch gekennzeichnet, dass die Anzahl der dritten MOSFETs (M3) kleiner ist als die Anzahl der Einheitszellen (EZ).

7. Bauelement nach einem der Ansprüche 1-6, dadurch gekennzeichnet, dass beim ersten MOSFET (M1) oder beim zweiten MOSFET (M2) oder bei beiden MOSFETs (M1,M2) unterhalb der entsprechenden Gateelektrode (G1 bzw. G2) an der zweiten Hauptoberfläche des Halbleitersubstrats (1) ein zusätzliches Kanal-Implantationsgebiet (13) vorgesehen ist, welches aus dem jeweiligen MOSFET einen MOSFET vom Verarmungstyp macht.

8. Bauelement nach einem der Ansprüche 1-7, dadurch gekennzeichnet, dass in jeder Einheitszelle (EZ) in das p-Kurzschlussgebiet (5) von der zweiten Hauptoberfläche her und angrenzend an das erste Kathodengebiet (4) ein p⁺-dotiertes Kontaktgebiet (12) eingelassen ist, welches von dem Kathodenkontakt (2) kontaktiert wird.

9. Bauelement nach einem der Ansprüche 1 bis 8, dadurch gekennzeichnet, dass alle Schichten (8,9,10) und Gebiete (4,5,6,7,12,13) innerhalb des Halbleitersubstrats (1) durch entsprechende Schichten und Gebiete mit komplementärer Dotierung ersetzt sind.

10. Bauelement nach einem der Ansprüche 1-3 und 5-6, dadurch gekennzeichnet, dass die zweite Gateelektrode (G2) des zweiten MOSFETs (M2) mit dem Kathodenkontakt (2) elektrisch direkt verbunden ist.

11. Verfahren zur Herstellung eines Leistungshalbleiter-Bauelements nach Anspruch 1, dadurch gekennzeichnet, dass
(a) zunächst in ein n⁻-dotiertes, die n-Basisschicht (9) bildendes Halbleitersubstrat (1) von der zweiten Hauptoberfläche her die p-Basisschicht (8) eingebracht wird;
(b) dann die zweite Hauptoberfläche des Halbleitersubstrats (1) ganzflächig mit einer isoliert aufgebauten Gateelektrodenschicht (14) bedeckt wird;
(c) dann in der Gateelektrodenschicht (14) die ersten Fenster (F1) geöffnet werden, welche in der Gateelektrodenschicht (14) die ersten und zweiten Gateelektroden (G1 bzw. G2) voneinander trennen; und
(d) schliesslich durch die ersten Fenster (F1) nacheinander die Abschaltgebiete (6) und die p-Kurzschlussgebiete (5) in die darunterliegende p-Basisschicht (8) eingelassen werden.

12. Verfahren nach Anspruch 11, dadurch gekennzeichnet, dass in der Gateelektrodenschicht (14) neben den ersten Fenstern (F1) zweite bzw. dritte Fenster (F2 bzw. F3) geöffnet werden, durch welche die zweiten Kathodengebiete (7) in die darunterliegende p-Basisschicht(8) eingelassen werden.

13. Verfahren nach einem der Ansprüche 11 und 12, dadurch gekennzeichnet, dass als Gateelektrodenschicht (14) eine Poly-Si-Schicht verwendet wird und das Einlassen der Gebiete (5,6,7) in die p-Basisschicht (8) mittels aufeinanderfolgender Implantationen (IM1,..,IM4) durch die Fenster (F1,F2,F3) und anschliessendem Drive-In durchgeführt wird.

## Claims

1. Turn-off power semiconductor component comprising
(a) a planar semiconductor substrate (1) having two oppositely situated principal surfaces, of which the first is designed as anode (A) and the second as cathode (K);
(b) in the semiconductor substrate (1) between the anode (A) and the cathode (K), a laterally continuous, n⁻-doped n-type base layer (9), a p⁺-doped anode layer (10) which is embedded in the n-type base layer (9) from the anode side and is provided with an anode contact (11) on the first principal surface, and a p⁺-doped p-type base layer (8) which is embedded in the n-type base layer (9) from the cathode side;
(c) a multiplicity of unit cells (EZ) arranged alongside one another and electrically connected in parallel in the semiconductor substrate (1) between the anode (A) and the cathode (K); and
(d) a first MOSFET (M1), which is provided for the purpose of turning off the component, arranged inside each unit cell (EZ) on the cathode side;
characterized in that, inside each unit cell (EZ),
(e) an n⁺-doped turn-off region (6) is embedded in the p-type base layer (8), a p⁺-doped p-type short-circuit region (5) is embedded in its turn in the turn-off region (6) and an n⁺-doped first cathode region (4) is embedded in its turn in the p-type short-circuit region (5), all from the cathode side, the p-type short-circuit region (5) and the first cathode region (4) being provided with a cathode contact (2) on the second principal surface;
(f) an n⁺⁺-doped second cathode region (7) which adjoins the turn-off region (6) is embedded in the p-type base layer (8) on one side of the turn-off region (6) from the cathode side;
(g) a first gate electrode (G1) and a second gate electrode (G2) are arranged alongside one another and in an insulated manner above the semiconductor substrate (1) on the cathode side and are isolated from one another by a first window (F1),
(aa) the first gate electrode (G1) spanning the part of the p-type short-circuit region (5) which emerges at the second principal surface on one side of the turn-off region (6) between the first cathode region (4) and the second cathode region (7) and forming together with said regions the first MOSFET (M1); and
(bb) the second gate electrode (G2) spanning the part of the turn-off region (6) which emerges at the second principal surface on the other side of the turn-off region (6) between the p-type short-circuit region (5) and the p-type base layer (8) and forming together with said regions or the layer a second MOSFET (M2); and
(h) the p-type short-circuit region (5) and the turn-off region (6) have been introduced into the semiconductor substrate (1) through the first window (F1).

2. Component according to Claim 1, characterized in that
(a) the various regions (4, 5, 6, 7) and gate electrodes (G1, G2) are arranged in each case in mirror-image fashion in adjacent unit cells (EZ); and
(b) the second gate electrodes (G2) of every two adjacent unit cells (EZ) are combined to form a common second gate electrode.

3. Component according to Claim 2, characterized in that
(a) the second cathode regions (7) of every two adjacent unit cells (EZ) are combined to form a common second cathode region; and
(b) the first gate electrodes (G1) of said adjacent unit cells (EZ) are isolated from one another by a second window (F2), through which second window (F2) the common second cathode region has been introduced into the semiconductor substrate (1).

4. Component according to Claim 3, characterized in that
(a) a third MOSFET (M3) for turning on the component is provided inside certain unit cells (EZ) on the cathode side;
(b) the third MOSFET (M3) produces a switchable connection between the n-type base layer (9) and the turn-off region (6); and
(c) the third MOSFET (M3) is formed from the n-type base layer (9) brought to the second principal surface underneath the second gate electrode (G2), the adjacent p-type base layer (8), the turn-off region (6) and the second gate electrode (G2).

5. Component according to Claim 2, characterized in that
(a) the p-type base layer (8) and the n-type base layer (9) are brought to the second principal surface between the second cathode regions (7) of two adjacent unit cells (EZ);
(b) an insulated third gate electrode (G3) is arranged above the parts of the p-type base layer (8) and of the n-type base layer (9) emerging at the second principal surface, which gate electrode is in each case isolated from the adjacent first gate electrodes (G1) by a third window (F3), through which third window (F3) the second cathode region (7) has in each case been introduced into the semiconductor substrate (1); and
(c) the second cathode region (7), the p-type base layer (8), the n-type base layer (9) and the third gate electrode (G3) form a third MOSFET (M3) which produces a switchable connection between the n-type base layer (9) and the turn-off region (6) and serves to turn on the component.

6. Component according to either of Claims 4 and 5, characterized in that the quantity of third MOSFETs (M3) is less than the quantity of unit cells (EZ).

7. Component according to any of Claims 1-6, characterized in that, in the first MOSFET (M1) or in the second MOSFET (M2) or in both MOSFETs (M1, M2) an additional channel implantation region (13), which makes a MOSFET of the depletion type out of the respective MOSFET, is provided underneath the corresponding gate electrode (G1 or G2) at the second principal surface of the semiconductor substrate (1).

8. Component according to any of Claims 1-7, characterized in that a p⁺-doped contact region (12), to which contact is made by the cathode contact (2), is embedded in the p-type short-circuit region (5) in each unit cell (EZ) from the second principal surface and adjacently to the first cathode region (4).

9. Component according to any of Claims 1 to 8, characterized in that all the layers (8, 9, 10) and regions (4, 5, 6, 7, 12, 13) inside the semiconductor substrate (1) are replaced by corresponding layers and regions having complementary doping.

10. Component according to any of Claims 1-3 and 5-6, characterized in that the second gate electrode (G2) of the second MOSFET (M2) is directly connected electrically to the cathode contact (2).

11. Process for producing a power semiconductor component according to Claim 1, characterized in that
(a) first the p-type base layer (8) is introduced into an n⁻-doped semiconductor substrate (1) forming the n-type base layer (9) from the second principal surface;
(b) then the entire area of the second principal surface of the semiconductor substrate (1) is coated with a gate electrode layer (14) having an insulated structure;
(c) then the first windows (F1) in the gate electrode layer (14) are opened, which windows isolate the first and second gate electrodes (G1 and G2) from one another in the gate electrode layer (14); and
(d) finally, the turn-off regions (6) and the p-type short-circuit regions (5) are successively embedded in the underlying p-type base layer (8) through the first windows (F1).

12. Process according to Claim 11, characterized in that second and third windows (F2 and F3) are opened in the gate electrode layer (14) alongside the first windows (F1), through which second and third windows the second cathode regions (7) are embedded in the p-type base layer (8) underneath.

13. Process according to either of Claims 11 or 12, characterized in that a poly-Si layer is used as gate electrode layer (14) and the regions (5, 6, 7) are embedded in the p-type base layer (8) by means of consecutive implantations (IM1, .., IM4) through the windows (F1, F2, F3) and subsequent drive-in.

## Revendications

1. Composant semiconducteur de puissance qui peut être bloqué, comportant
(a) un substrat semiconducteur (1) planaire avec deux surfaces principales opposées, dont la première est conçue comme anode (A) et la seconde comme cathode (K);
(b) dans le substrat semiconducteur (1) entre l'anode (A) et la cathode (K) une couche de base latéralement continue de type n dopée n⁻ (9), une couche d'anode dopée p⁺ (10) qui est enterrée dans la couche de base de type n (9) à partir du côté de l'anode et qui est pourvue d'un contact d'anode (11) sur la première surface principale, et une couche de base de type p dopée p⁺ (8) qui est enterrée dans la couche de base de type n (9) à partir du côté de la cathode;
(c) dans le substrat semiconducteur (1) entre l'anode (A) et la cathode (K), une multiplicité de cellules unitaires (EZ) disposées côte à côte et connectées électriquement en parallèle; et
(d) dans chaque cellule unitaire (EZ), un premier MOSFET (M1), disposé du côté de la cathode, qui est destiné à bloquer le composant;
caractérisé en ce que dans chaque cellule unitaire (EZ),
(e) à partir du côté de la cathode sont enterrées dans la couche de base de type p (8), une zone de blocage dopée n⁺ (6), dans cette zone de blocage (6) elle-même une zone de court-circuit de type p dopée p⁺ (5), et dans la zone de court-circuit de type p (5) elle-même une première zone de cathode dopée n⁺ (4), la zone de court-circuit de type p (5) et la première zone de cathode (4) sur la seconde surface principale étant pourvues d'un contact de cathode (2);
(f) sur un des côtés de la zone de blocage (6) à partir du côté de la cathode, dans la couche de base de type p (8) est enterrée une seconde zone de cathode dopée n⁺⁺ (7) qui jouxte la zone de blocage (6);
(g) une première et une seconde électrodes de commande (respectivement G1 et G2) sont disposées côte à côte et de manière isolée par-dessus le substrat semiconducteur (1) du côté de la cathode, et séparées l'une de l'autre par une première fenêtre (F1), où
(aa) la première électrode de commande (G1) couvre la partie de la zone de court-circuit de type p (5) émergeant sur la seconde surface principale, sur un des côtés de la zone de blocage (6), entre la première zone de cathode (4) et la seconde zone de cathode (7), et constitue avec ces différentes zones le premier MOSFET (M1); et
(bb) la seconde électrode de commande (G2) couvre la partie de la zone de blocage (6) émergeant sur la seconde surface principale, sur l'autre côté de la zone de blocage (6), entre la zone de court-circuit de type p (5) et la couche de base de type p (8), et constitue avec ces différentes zones ou avec la couche, un second MOSFET (M2); et
(h) la zone de court-circuit de type p (5) et la zone de blocage (6) ont été introduites dans le substrat semiconducteur (1) à travers la première fenêtre (F1).

2. Composant suivant la revendication 1, caractérisé en ce que
(a) dans des cellules unitaires (EZ) voisines, les différentes zones (4, 5, 6, 7) et électrodes de commande (G1, G2) sont chaque fois disposées selon une symétrie de miroir; et
(b) les secondes électrodes de commande (G2) de chaque paire de cellules unitaires (EZ) voisines sont regroupées pour former une seconde électrode de commande commune.

3. Composant suivant la revendication 2, caractérisé en ce que
(a) les secondes zones de cathode (7) de chaque paire de cellules unitaires (EZ) voisines sont regroupées pour former une seconde zone de cathode commune; et
(b) les premières électrodes de commande (G1) de ces cellules unitaires (EZ) voisines sont séparées l'une de l'autre par une seconde fenêtre (F2) à travers laquelle seconde fenêtre (F2) la totalité de la seconde zone de cathode a été introduite dans le substrat semiconducteur (1).

4. Composant suivant la revendication 3, caractérisé en ce que
(a) un troisième MOSFET (M3) est prévu à l'intérieur de certaines cellules unitaires (EZ) du côté de la cathode pour enclencher le composant;
(b) le troisième MOSFET (M3) établit une liaison commutable entre la couche de base de type n (9) et la zone de blocage (6); et
(c) le troisième MOSFET (M3) est constitué de la couche de base de type n (9) qui s'étend jusqu'à la seconde couche principale sous la seconde électrode de commande (G2), de la couche de base de type p (8) contiguë, de la zone de blocage (6) et de la seconde électrode de commande (G2).

5. Composant suivant la revendication 4, caractérisé en ce que
(a) la couche de base de type p (8) et la couche de base de type n (9) sont étendues jusqu'à la seconde surface principale entre les secondes zones de cathode (7) de deux cellules unitaires (EZ) voisines ;
(b) on dispose une troisième électrode de commande (G3) isolée par-dessus les parties de la couche de base de type p (8) et de la couche de base de type n (9) qui émergent sur la seconde surface principale, cette électrode de commande (G3) étant à chaque fois séparée des premières électrodes de commandes (G1) voisines par une troisième fenêtre (F3) à travers laquelle troisième fenêtre (F3) on a introduit à chaque fois la seconde zone de cathode (7) dans le substrat semiconducteur (1); et
(c) la seconde zone de cathode (7), la couche de base de type p (8), la couche de base de type n (9) et la troisième électrode de commande (G3) forment un troisième MOSFET (M3) qui établit une liaison commutable entre la couche de base de type n (9) et la zone de blocage (6) et qui sert à l'enclenchement du composant.

6. Composant suivant l'une ou l'autre des revendications 4 et 5, caractérisé en ce que le nombre de troisièmes MOSFETs (M3) est inférieur au nombre de cellules unitaires (EZ).

7. Composant suivant l'une quelconque des revendications 1-6, caractérisé en ce que pour le premier MOSFET (M1) ou pour le second MOSFET (M2) ou pour les deux MOSFETs (M1, M2), une zone supplémentaire d'implantation d'un canal (13) est prévue à la seconde surface principale du substrat semiconducteur (1) en dessous de l'électrode de commande correspondante (G1 respectivement G2), cette zone supplémentaire d'implantation transformant le MOSFET correspondant en MOSFET de type appauvri.

8. Composant suivant l'une quelconque des revendications 1-7, caractérisé en ce qu'une zone de contact dopée p⁺ (12) est enterrée dans la zone de court-circuit de type p (5) de chaque cellule unitaire (EZ) à partir de la seconde surface principale et contiguë à la première zone de cathode (4), cette zone de contact dopée p⁺ (12) étant mise en contact par le contact de cathode (2).

9. Composant suivant l'une quelconque des revendications 1 à 8, caractérisé en ce que toutes les couches (8, 9, 10) et les zones (4, 5, 6, 7, 12, 13) à l'intérieur du substrat semiconducteur (1) sont remplacées par des couches et des zones correspondantes comportant un dopage complémentaire.

10. Composant suivant l'une quelconque des revendications 1-3 et 5-6, caractérisé en ce que la seconde électrode de commande (G2) du second MOSFET (M2) est directement raccordée électriquement avec le contact de cathode (2).

11. Procédé de fabrication d'un composant semiconducteur de puissance suivant la revendication 1 caractérisé en ce que
(a) en premier lieu, la couche de base de type p (8) est introduite dans un substrat semiconducteur dopé n⁻ (1) constituant la couche de base de type n (9) à partir de la seconde surface principale;
(b) ensuite la seconde surface principale du substrat semiconducteur (1) est entièrement recouverte par une couche d'électrodes de commande (14) réalisée de manière isolée;
(c) on ouvre ensuite les premières fenêtres (F1) dans la couche d'électrodes de commande (14), ces première fenêtres (F1) séparant les unes des autres les premières électrodes de commande (G1) des secondes électrodes de commande (G2) dans la couche d'électrodes de commande (14); et
(d) enfin les zones de blocage (6) et les zones de court-circuit de type p (5) sont enterrées successivement dans la couche de base de type p (8) sous-jacente à travers les premières fenêtres (F1).

12. Procédé suivant la revendication 11, caractérisé en ce qu'on ouvre les secondes respectivement troisièmes fenêtres (F2 respectivement F3) à côté des premières fenêtres (F1) dans la couche d'électrodes de commande (14), secondes et troisièmes fenêtres (F2 respectivement F3) à travers lesquelles on enterre les secondes zones de cathode (7) dans la couche de base de type p (8) sous-jacente.

13. Procédé suivant l'une ou l'autre des revendications 11 et 12, caractérisé en ce qu'on utilise une couche de poly-Si comme couche d'électrodes de commande (14) et que l'enterrement des zones (5, 6, 7) dans la couche de base de type p (8) est réalisé par des implantations successives (IM1, ..., IM4) à travers les fenêtres (F1, F2, F3) et ensuite par Drive-In.
